(19) Europäisches Patentamt / European Patent Office / Office européen des brevets

(11) **EP 3 259 608 B1**

(12) **FASCICULE DE BREVET EUROPEEN**

(45) Date de publication et mention
de la délivrance du brevet:
**21.11.2018 Bulletin 2018/47**

(51) Int Cl.:
**G01R 31/08** *(2006.01)*     **G01R 31/11** *(2006.01)*

(21) Numéro de dépôt: **16706814.7**

(22) Date de dépôt: **12.02.2016**

(86) Numéro de dépôt international:
**PCT/EP2016/053029**

(87) Numéro de publication internationale:
**WO 2016/131721 (25.08.2016 Gazette 2016/34)**

(54) **PROCEDE DE CARACTERISATION D'UN DEFAUT NON FRANC DANS UN CABLE**

VERFAHREN ZUR CHARAKTERISIERUNG EINES UNKLAREN FEHLERS IN EINEM KABEL

METHOD FOR CHARACTERISING AN UNCLEAR FAULT IN A CABLE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.02.2015 FR 1551263**

(43) Date de publication de la demande:
**27.12.2017 Bulletin 2017/52**

(73) Titulaire: **Commissariat à l'Énergie Atomique
et aux Énergies Alternatives
75015 Paris (FR)**

(72) Inventeurs:
 • **SALLEM, Soumaya
 60180 Nogent sur Oise (FR)**
 • **RAVOT, Nicolas
 77500 Chelles (FR)**

(74) Mandataire: **Hammes, Pierre et al
Marks & Clerk France
Immeuble Visium
22, avenue Aristide Briand
94117 Arcueil Cedex (FR)**

(56) Documents cités:
**JP-A- 2008 157 897**

 • **MAUD FRANCHET ET AL: "Soft fault detection in
cables using the cluster time-frequency domain
reflectometry", IEEE ELECTROMAGNETIC
COMPATIBILITY MAGAZINE, IEEE,
PISCATAWAY, NJ, USA, vol. 2, no. 1, 1 janvier
2013 (2013-01-01) , pages 54-69, XP011510140,
ISSN: 2162-2264, DOI:
10.1109/MEMC.2013.6512221**
 • **LAYANE ABBOUD ET AL: "Utilization of matched
pulses to improve fault detection in wire
networks", INTELLIGENT TRANSPORT
SYSTEMS TELECOMMUNICATIONS,(ITST),2009
9TH INTERNATIONAL CONFERENCE ON, IEEE,
PISCATAWAY, NJ, USA, 20 octobre 2009
(2009-10-20), pages 543-548, XP031619128, ISBN:
978-1-4244-5346-7**
 • **SALLEM SOUMAYA ET AL: "Self-adaptive
correlation method for soft defect detection in
cable by reflectometry", IEEE SENSORS 2014
PROCEEDINGS, IEEE, 2 novembre 2014
(2014-11-02), pages 2114-2117, XP032705584,
DOI: 10.1109/ICSENS.2014.6985455**

**Description**

L'invention concerne un procédé et un système de caractérisation d'un défaut non franc impactant un câble électrique. Le domaine de l'invention est celui des systèmes de diagnostic filaires basés sur le principe de la réflectométrie, en particulier celui de la réflectométrie temporelle.

Les câbles sont omniprésents dans tous les systèmes électriques, pour l'alimentation ou la transmission d'information. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts, mais aussi leur localisation et leur type, afin d'aider à la maintenance. Les méthodes de réflectométrie usuelles permettent ce type de tests.

Les méthodes de réflectométrie utilisent un principe proche de celui du radar : un signal électrique, le signal de sonde, souvent de haute fréquence ou large bande, est injecté en un ou plusieurs endroits du câble à tester. Ledit signal se propage dans le câble ou le réseau et renvoie une partie de son énergie lorsqu'il rencontre une discontinuité électrique. Une discontinuité électrique peut résulter, par exemple, d'un branchement, de la fin du câble ou d'un défaut ou plus généralement d'une rupture des conditions de propagation du signal dans le câble. Elle résulte le plus souvent d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne «Time Domain Reflectometry » et FDR venant de l'expression anglo-saxonne « Frequency Domain Reflectometry ».

L'invention s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre pourvu qu'il soit possible d'y injecter un signal de réflectométrie et de mesurer sa réflexion.

Les méthodes de réflectométrie temporelle connues sont particulièrement adaptées à la détection de défauts francs dans un câble, tel un court circuit ou un circuit ouvert ou plus généralement une modification locale significative de l'impédance du câble. La détection du défaut se fait par la mesure de l'amplitude du signal réfléchi sur ce défaut qui est d'autant plus importante et donc détectable, que le défaut est franc.

A l'inverse, un défaut non franc, par exemple résultant d'une dégradation superficielle de la gaine du câble de l'isolant ou du conducteur, engendre un pic d'amplitude faible sur le signal de réflectométrie réfléchi et est par conséquent plus difficilement détectable par des méthodes temporelles classiques. Les défauts non francs peuvent notamment mais pas exclusivement comprendre les défauts du type éraflure ou usure de la gaine diélectrique, un début de dégradation du conducteur métallique ou encore la compression d'un câble.

La détection et la localisation d'un défaut non franc sur un câble est un problème important pour le monde industriel car un défaut apparait en général d'abord comme un défaut superficiel mais peut, avec le temps, évoluer vers un défaut plus impactant. Pour cette raison notamment, il est utile de pouvoir détecter l'apparition d'un défaut dès son apparition et à un stade où son impact est superficiel afin d'anticiper son évolution en un défaut plus important.

En outre, un objectif visé par les méthodes d'analyse par réflectométrie est également de déterminer la taille et l'impédance caractéristique d'un défaut non franc.

Lorsque le signal de réflectométrie utilisé est une impulsion temporelle, le signal réfléchi sur les discontinuités d'impédance liées au défaut non franc, présente une signature qui est constituée de deux impulsions de signes opposés. Ces impulsions sont partiellement superposées du fait que la largeur de l'impulsion temporelle est supérieure à la taille du défaut non franc le plus souvent. Il en résulte une déformation de la véritable signature du défaut, causant ainsi une perte d'informations concernant les caractéristiques précises du défaut, notamment sa position, sa taille et son impédance caractéristique.

Un objectif général de l'invention est d'améliorer l'estimation de la position, de la taille et de l'impédance caractéristique d'un défaut non franc lors de la mise en oeuvre d'une analyse par réflectométrie temporelle.

Une première solution pour résoudre le problème évoqué ci-dessus est de diminuer la taille de l'impulsion temporelle du signal injecté dans le câble de sorte à ce que cette largeur soit inférieure à la longueur du défaut non franc que l'on souhaite détecter. Cependant cette méthode se heurte aux limites en termes de bande passante fréquentielle disponible pour les signaux injectés dans le câble à analyser.

Diverses techniques ont été proposées, dans la littérature, pour pallier au problème évoqué ci-dessus lié à la superposition ou l'empilement d'impulsions lors de la réflexion du signal sur les discontinuités d'impédance liées à un défaut non franc. Il a ainsi été montré, que l'utilisation d'outils de traitement du signal, comme le filtrage linéaire à réponse impulsionnelle finie permet de désempiler deux impulsions en conservant une impulsion et rejetant la deuxième qui est considérée comme du bruit. Une telle méthode est notamment décrite dans le document [1]. Cette méthode présente des inconvénients liés à la perte d'information concernant la deuxième impulsion ce qui réduit son champ d'application et la dépendance de son efficacité aux paramètres du filtre.

Une autre méthode de désempilement d'impulsions est décrite dans les documents [2], [3]. Cette méthode, appliquée dans le domaine de la spectroscopie, est basée sur une approche probabiliste. Elle consiste en un procédé de mesure comportant une succession d'impulsions principales de durées espacées temporellement les unes des autres et pouvant être constituées chacune d'un empilement d'impulsions élémentaires de durée X et dont l'énergie est évaluée par une variable Y possédant une propriété d'additivité. Les impulsions élémentaires ont des instants d'apparition $T_i$ qui suivent un processus de Poisson homogène. Les limites de cette approche résident dans sa complexité et au fait qu'elle n'est applicable que quand le processus d'arrivée des impulsions est connu ou possible à déterminer.

On connait également l'article [4] dont les auteurs présentent une méthode numérique pour le traitement des impulsions empilées dans les spectres issus des détecteurs en germanium (pour les radiations X et Gamma). Dans cette approche, des techniques d'acquisition numérique ont été utilisées pour enregistrer les formes d'onde empilées qui sont traitées par la suite par un algorithme de type « fitting » ou de dé-convolution afin de récupérer les impulsions d'origine. La méthode est basée sur un ajustement approprié des signaux détectés, avec un filtrage numérique de mise en forme d'impulsions approprié. L'analyse est présentée pour les événements d'empilement formés par deux signaux, et peut être étendue à l'empilement de plusieurs signaux.

Cette méthode ne peut néanmoins pas être appliquée pour la signature d'un défaut non franc car elle nécessite une connaissance préalable de la période temporelle des impulsions ainsi qu'une bonne précision concernant la détection de début de l'empilement. Elle ne peut pas séparer des impulsions empilées de sens opposés (empilement destructif) et ne permet pas de séparer des impulsions très proches. Elle reste limitée par son principal inconvénient qui consiste en sa complexité de calcul qui la rend difficile à intégrer sur une carte électronique.

On connait par ailleurs, la méthode décrite dans la demande de brevet japonaise JP2008157897, qui concerne également le domaine du diagnostic filaire.

La présente invention vise à proposer une solution alternative aux méthodes de l'art antérieur qui permet de résoudre le problème de la superposition d'impulsions lors de la réflexion du signal d'analyse sur un défaut non franc. L'invention propose une méthode et un dispositif qui permet de déterminer avec précision la longueur du défaut non franc, son impédance caractéristique ainsi que sa position sur le câble.

L'invention a ainsi pour objet un procédé de caractérisation d'un défaut impactant un câble dans lequel un signal de référence s de support temporel limité est injecté et une mesure r de la réflexion dudit signal de référence s dans le câble est réalisée, caractérisé en ce que ledit procédé comprend les étapes suivantes :

- Identifier une portion de la mesure r correspondant à un défaut, cette portion de mesure étant appelée signature du défaut,
- Générer un signal de référence s' modifié, d'amplitude paramétrable, égal à la somme dudit signal de référence s et dudit signal de référence s inversé et retardé d'un retard paramétrable,
- Déterminer conjointement les valeurs du retard paramétrable et de l'amplitude paramétrable qui minimisent l'erreur entre le signal de référence s' modifié et la signature du défaut,
- En déduire une estimation de la longueur du défaut à partir de la valeur dudit retard déterminée.

Selon une variante de réalisation, le procédé selon l'invention comprend en outre l'étape suivante :

- Déduire, à partir de la valeur d'amplitude déterminée, une estimation du coefficient de réflexion du signal au niveau du défaut puis une estimation de l'impédance caractéristique du câble au niveau du défaut.

Selon une variante de réalisation, la durée du support temporel du signal de référence s est rendue paramétrable et le procédé selon l'invention comprend en outre une étape de détermination de la valeur de ladite durée qui minimise l'erreur entre le signal de référence s' modifié et la signature du défaut.

Selon une variante de réalisation, le procédé selon l'invention comprend en outre les étapes suivantes :

- Déterminer une estimation de la position du milieu du défaut à partir de la signature du défaut dans la mesure r de la réflexion du signal de référence,
- Déterminer une estimation de la position du début du défaut en retranchant à la position du milieu du défaut la moitié de la longueur du défaut.

Selon une variante de réalisation, on détermine une estimation de la position du milieu du défaut à partir du milieu de l'intervalle temporel [t1 ; t2] avec t1 l'abscisse temporelle de l'amplitude maximum de la signature du défaut et t2 l'abscisse temporelle de l'amplitude minimum de la signature du défaut.

Selon un aspect particulier de l'invention, le signal de référence s est une impulsion temporelle.

L'invention a également pour objet un programme d'ordinateur comportant des instructions pour l'exécution du procédé de caractérisation d'un défaut impactant un câble selon l'invention, lorsque le programme est exécuté par un processeur ainsi qu'un support d'enregistrement lisible par un processeur sur lequel est enregistré un programme comportant des instructions pour l'exécution du procédé de caractérisation d'un défaut impactant un câble selon l'invention, lorsque le programme est exécuté par un processeur.

L'invention a encore pour objet un dispositif de caractérisation d'un défaut impactant un câble comprenant des moyens d'injection d'un signal de référence s en un point du câble, des moyens de mesure d'une réflexion r dudit signal dans le câble et des moyens de calcul adaptés pour mettre en oeuvre le procédé de caractérisation d'un défaut impactant un câble selon l'invention.

D'autres caractéristiques et avantages de la présente invention apparaîtront mieux à la lecture de la description qui suit en relation aux dessins annexés qui représentent :

- Les figures 1a et 1b, deux schémas illustrant le phénomène de superposition d'impulsions dans le contexte de la caractérisation de défauts non francs sur un câble,
- La figure 2, un organigramme illustrant les étapes de mise en oeuvre du procédé de caractérisation de défauts selon l'invention,
- La figure 3, un schéma illustrant l'étape de génération d'un signal de référence modifié s',
- La figure 4, un schéma illustrant l'étape de détermination de la position d'un défaut non franc,
- La figure 5, un schéma d'un exemple de dispositif configuré pour mettre en oeuvre l'invention.

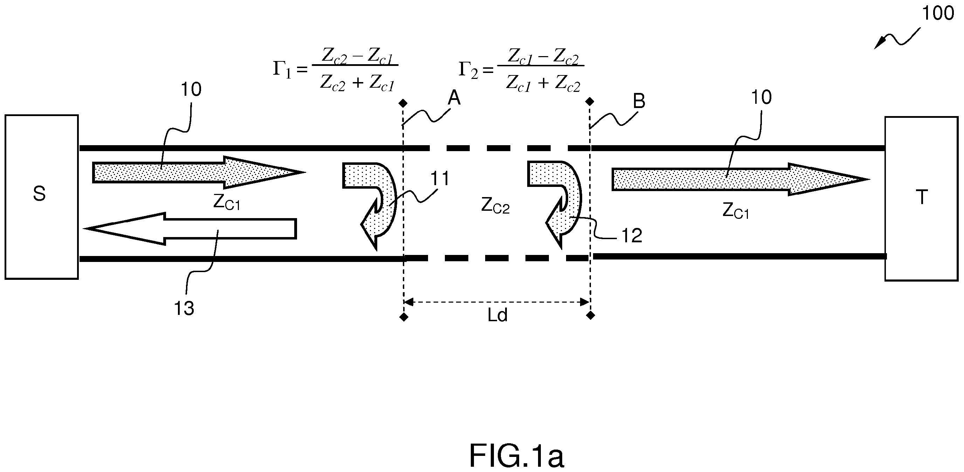

La figure 1a représente, sur un schéma, une ligne de transmission 100, par exemple un câble électrique, d'extrémités notées S et T.

Le câble 100 est affecté d'un défaut non franc, par exemple une dégradation superficielle de la gaine du câble, qui s'étend du point A au point B sur le câble.

Selon un principe bien connu, afin de localiser le défaut, on applique une méthode dite de réflectométrie qui consiste à injecter un signal 10 de forme maitrisée à une extrémité S du câble. Ce signal peut être un signal à support temporel limité, par exemple une impulsion temporelle, on parle alors de réflectométrie temporelle. Le signal incident 10 se propage le long du câble 100 et rencontre un premier point A correspondant au début du défaut non franc. En ce point A, une première discontinuité d'impédance peut être observée lorsque le signal passe d'un milieu d'impédance caractéristique $Z_{c1}$ correspondant au câble sain vers un milieu d'impédance caractéristique $Z_{c2}$ correspondant au câble affecté par le défaut non franc. Ce dernier provoque une variation d'impédance caractéristique très faible, typiquement de l'ordre de quelques Ohms.

Le signal incident 10 se réfléchi au point A pour produire un premier signal réfléchi 11 puis au point B pour produire un second signal réfléchi 12. Le premier signal réfléchi 11 et le second signal réfléchi 12 sont de signes inversés du fait que le premier signal réfléchi correspond à une réflexion du milieu d'impédance caractéristique $Z_{c1}$ vers le milieu d'impédance caractéristique $Z_{c2}$ et le second signal réfléchi correspond à une réflexion du milieu d'impédance caractéristique $Z_{c2}$ vers le milieu d'impédance caractéristique $Z_{c1}$.

Les deux signaux réfléchis 11,12 se superposent en un signal réfléchi global 13 qui est rétro propagé jusqu'au point d'injection S.

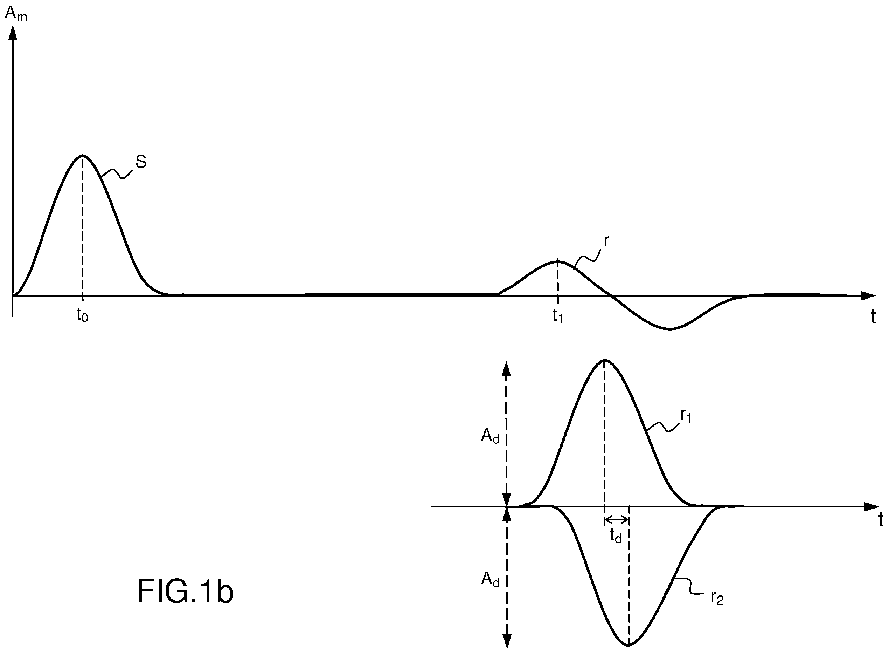

La figure 1b illustre (sur la partie haute de la figure) un réflectogramme temporel obtenu après l'injection au point S du câble 100 d'une impulsion temporelle 10 et la mesure en ce même point S du signal réfléchi 13.

On observe sur le réflectogramme temporel, l'impulsion temporelle s injectée et la signature r du signal réfléchi 13 sur le défaut non franc.

Cette signature r résulte, comme indiqué sur la partie basse de la figure 1b, de la superposition d'une première impulsion $r_1$ réfléchie sur l'entrée du défaut et d'une seconde impulsion $r_2$, de signe opposé à la première impulsion et réfléchie sur la sortie du défaut.

La superposition ou l'empilement de ces deux impulsions engendre une signature r qui ne permet pas de caractériser correctement le défaut. En effet, son amplitude et sa largeur ne sont pas directement exploitables pour déduire l'impédance caractéristique et la longueur du défaut car elles sont déformées par rapport à l'impulsion réellement injectée dans le câble. Par exemple, la mesure de la largeur de l'impulsion réfléchie r ne permet pas de déterminer directement une mesure de la longueur du défaut.

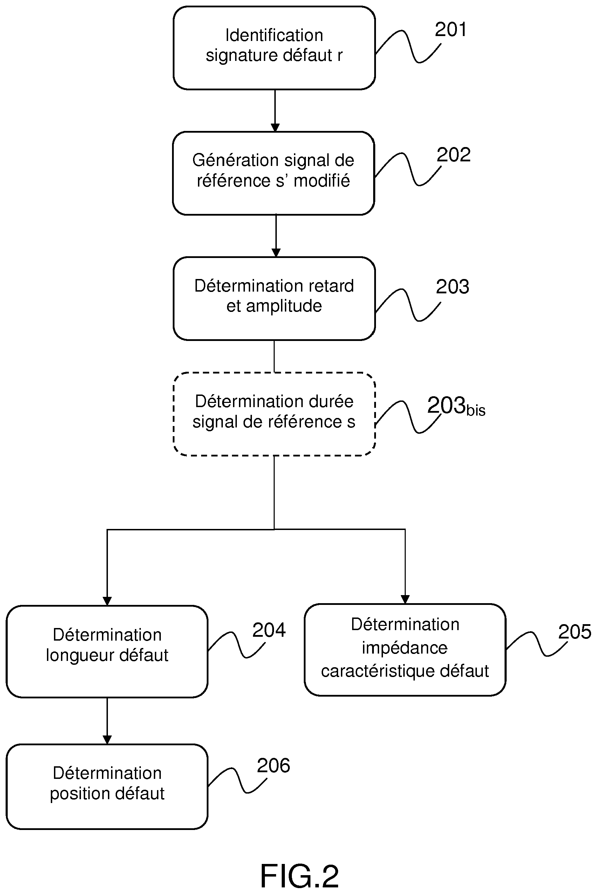

Pour pallier ce problème, l'invention propose le procédé décrit à la figure 2 qui comprend les étapes suivantes.

Selon une première étape 201, on identifie, dans le réflectogramme mesuré, la signature r correspondant à un défaut non franc. Autrement dit, on isole dans le réflectogramme mesuré, la portion de la mesure qui semble correspondre à une réflexion du signal sur un défaut non franc.

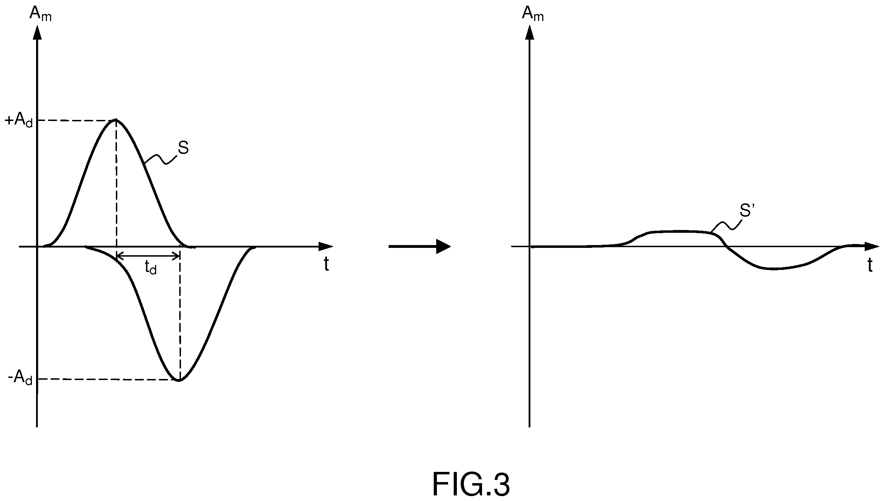

Selon une deuxième étape 202, on génère un signal de référence s' modifié à partir du signal de référence s injecté dans le câble. Le signal de référence s' modifié est obtenu en sommant le signal de référence s et ce même signal inversé et retardé d'une durée paramétrable $t_d$. Cette opération est illustrée à la figure 3 qui représente, sur la gauche de la figure, le signal de référence s et son inverse retardé d'une durée $t_d$, et sur la droite de la figure, le signal de référence modifié s' obtenu en sommant le signal de référence s et ce signal inversé et retardé. L'amplitude $A_d$ du signal s' modifié est rendu également paramétrable.

Selon une troisième étape 203, on calcule l'erreur entre le signal de référence modifié s' et la signature r mesurée et isolée à la première étape 201. Cette erreur peut être déterminée en calculant la somme de la valeur absolue des différences, point à point entre le signal de référence modifié s' et la signature r. Au préalable, on aligne les deux signaux temporellement sur un point de référence commun qui peut être, par exemple, le milieu de l'intervalle entre l'abscisse du point d'amplitude maximale et l'abscisse du point d'amplitude minimale.

L'erreur entre le signal de référence modifié et la signature r peut être déterminée par d'autres critères utilisés dans les algorithmes de maximisation de vraisemblance connus. En particulier cette erreur peut être égale à la somme des différences élevées au carré entre un point du signal de référence modifié s' et un point de la signature r.

L'erreur entre le signal de référence modifié s' et la signature r peut être minimisée par d'autres critères utilisés dans les algorithmes de maximisation de vraisemblance connus.

En particulier cette erreur peut être égale à la racine de la somme des différences élevées au carré entre le signal s' et la signature r, point à point. Plus généralement, l'erreur peut également être égale à la somme élevée à la puissance 1/p des valeurs absolues des différences point à point élevées à la puissance p entre les deux signaux.

$$E = \left( \sum_k |s'(k) - r(k)|^p \right)^{1/p}$$

On recherche ensuite la valeur du retard $t_d$ et la valeur de l'amplitude $A_d$ qui permettent d'obtenir l'erreur la plus faible entre les deux signaux comparés. Pour cela, on effectue un processus itératif qui consiste à modifier la valeur du retard $t_d$, par exemple en lui faisant parcourir une plage de valeurs prédéterminées, et à calculer pour chaque valeur, l'erreur correspondante entre les deux signaux. De même, pour chaque valeur du retard $t_d$, on fait varier l'amplitude $A_d$ dans une plage de valeurs prédéterminées et on calcule, pour chaque valeur d'amplitude, l'erreur correspondante entre les deux signaux. Au final, on retient la valeur du retard et la valeur de l'amplitude qui permettent d'obtenir l'erreur la plus faible. Ce processus constitue une méthode de maximisation de vraisemblance. La recherche des valeurs de retard et d'amplitude permettant de minimiser l'erreur entre les deux signaux se fait conjointement.

La valeur du retard $t_d$ retenue in fine correspond à la durée s'écoulant entre la réflexion du signal injecté sur le point d'entrée du défaut et la réflexion du signal injecté sur le point de sortie du défaut. A partir de cette durée, il est possible d'en déduire une estimée de la longueur du défaut.

Selon une variante de réalisation de l'invention, un troisième paramètre optionnel peut être ajouté pour configurer le signal de référence modifié s' en plus du retard $t_d$ et de l'amplitude $A_d$. Ce troisième paramètre est la durée du support temporel du signal de référence s. De la même façon qu'expliqué ci-dessus, la durée du support temporel du signal de référence peut être rendue variable dans une plage de valeurs prédéterminées. Ce paramètre peut alors être intégré dans la méthode de maximisation de vraisemblance de la façon suivante. Une fois les valeurs de retard et d'amplitude optimales déterminées à l'issue de l'étape 203, on calcule, dans une étape supplémentaire 203$_{bis}$ à nouveau l'erreur entre le signal de référence modifié s' et la signature r pour chaque valeur de durée possible du support temporel du signal de référence. On retient à l'issue de l'étape 203$_{bis}$ la valeur de durée qui donne l'erreur la plus faible.

L'étape 203$_{bis}$ de détermination de la durée optimale du support temporel du signal de référence peut être exécutée successivement à l'étape 203 de détermination conjointe des valeurs optimales de retard et d'amplitude mais peut aussi être exécutée avant cette étape 203.

Dans une étape successive 204, on estime ainsi la longueur du défaut non franc à partir de la valeur du retard retenue à l'étape 203. La longueur du défaut peut, par exemple être obtenue à l'aide de la relation suivante : $L = V.t_d/2$ où V est la vitesse de propagation du signal dans le câble. La vitesse de propagation peut, par exemple, être obtenue à partir de la connaissance de la longueur totale du câble et de la durée entre l'instant d'injection du signal dans le câble et sa réflexion sur l'extrémité du câble, cette durée pouvant être mesurée sur le réflectogramme temporel.

Il convient de noter pour être rigoureux que la vitesse de propagation du signal à travers le défaut peut varier légèrement par rapport à la vitesse de propagation nominale du câble. En toute rigueur, il serait nécessaire d'utiliser une mesure V de la vitesse de propagation du signal à travers le défaut. Cependant, en pratique, une mesure V de la vitesse de propagation du signal dans le câble, qui peut être fournie par le constructeur du câble, est suffisante pour obtenir une mesure précise de la longueur du défaut L à partir de la valeur du retard $t_d$.

A partir de la valeur d'amplitude obtenue, on en déduit, dans une étape 205, une estimée de l'impédance caractéristique du défaut non franc. Cette estimée peut être obtenue en considérant la valeur d'amplitude retenue comme une estimée du coefficient de réflexion du signal au niveau du défaut non franc et à partir d'une connaissance de l'impédance caractéristique du câble à l'aide de la relation suivante bien connue.

$$\Gamma = \frac{Z_{c2} - Z_{c1}}{Z_{c2} + Z_{c1}},$$ où $\Gamma$ est le coefficient de réflexion, $Z_{c1}$ l'impédance caractéristique du câble et $Z_{c2}$ l'impédance caractéristique du défaut non franc.

Dans une variante de réalisation de l'invention, une étape supplémentaire 206 est ajoutée au procédé dans le but de déterminer précisément la position du début du défaut sur le câble.

L'identification de la signature r du défaut non franc dans le réflectogramme, permet une première estimation grossière de la position du défaut sur le câble. Cette estimation est par exemple obtenue à partir de la mesure du délai, sur le réflectogramme temporel, entre l'abscisse $t_0$ du sommet de l'impulsion de signal injectée correspondant au point d'injection et l'abscisse $t_1$ du sommet de l'impulsion r correspondant à la signature du défaut non franc sur le réflectogramme.

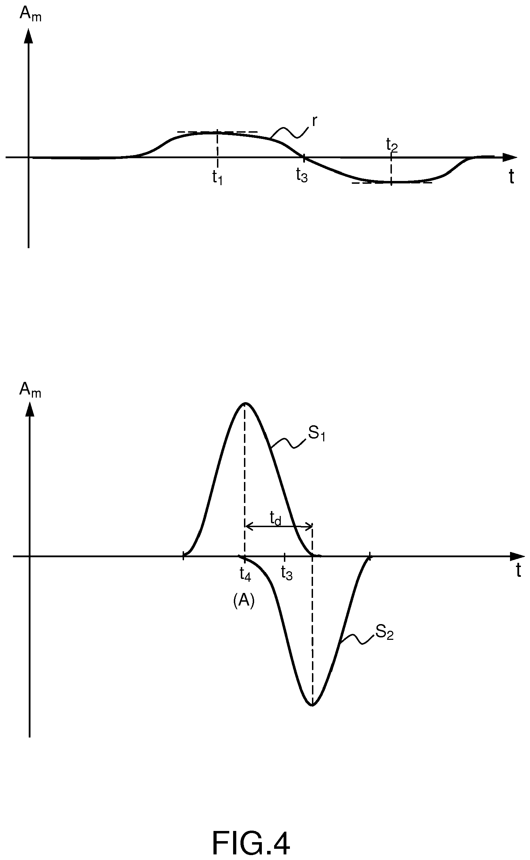

La figure 4 illustre la mise en oeuvre de l'étape 206 d'affinement de l'estimation de la position du défaut.

Sur le haut de la figure 4 est représenté le réflectogramme temporel de la signature r mesurée du défaut non franc.

Sur ce réflectogramme, on mesure un point de référence $t_3$ correspondant au milieu du défaut non franc. L'instant $t_3$ est par exemple égal au milieu de l'intervalle temporel $[t_1 ; t_2]$ avec $t_1$ l'abscisse temporelle correspondant au maximum d'amplitude de la mesure r et $t_2$ l'abscisse temporelle correspondant au minimum d'amplitude de la mesure r.

Sur le bas de la figure 4 sont représentées les deux impulsions $s_1$ et $s_2$ écartées d'un retard temporel td, qui servent de base à la génération du signal de référence s' modifié tel qu'expliqué dans l'étape 202 du procédé. On centre l'ensemble composé des deux impulsions $s_1$ et $s_2$ sur l'instant $t_3$ mesuré sur la signature r de sorte à centrer cet ensemble sur un point correspondant au milieu du défaut non franc.

A partir du réflectogramme illustré sur le bas de la figure 4, on voit que la position réelle du point A de début du défaut non franc correspond, sur le réflectogramme, à un instant temporel retardé de td/2 par rapport à l'instant $t_3$. A partir de cette constatation, on détermine donc l'instant temporel $t_4$ correspondant au début réel du défaut non franc comme étant égal à $t_4 = t_3 - td/2$, td étant le retard retenu à l'issue de l'étape 203 du procédé.

A partir de l'instant temporel $t_4$, on en déduit la position réelle du début du défaut soit à partir de la vitesse de propagation du signal dans le câble ou par relation de proportionnalité en connaissant la longueur du câble.

L'étape 206 d'affinement de la position du défaut prend en compte la durée du support temporel du signal de référence obtenue à l'issue de l'étape 203$_{bis}$ lorsque celle-ci est mise en oeuvre.

Bien que les exemples donnés aux figures 1 à 4 représentent un signal de référence sous la forme d'une impulsion Gaussienne, l'invention n'est pas limitée à cette seule forme de signal et s'applique pour tout signal de réflectométrie ayant un support temporel limité.

L'invention présente l'avantage de permettre une estimation plus fiable des caractéristiques de longueur, position et impédance caractéristique d'un défaut non franc.

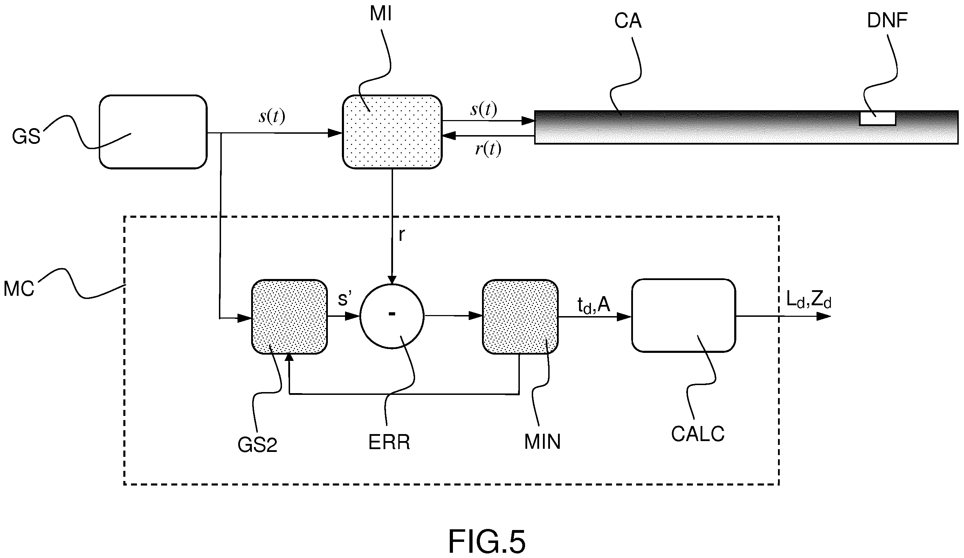

La figure 5 schématise, sur un synoptique, un exemple de système de réflectométrie apte à mettre en oeuvre le procédé selon l'invention.

Un système de réflectométrie, ou réflectomètre, comporte au moins un moyen GS, pour générer un signal de test s et l'injecter dans le câble à analyser CA, un moyen de mesure MI pour mesurer le signal réfléchi r dans le câble CA et un composant électronique MC de type circuit intégré, tel un circuit à logique programmable, par exemple de type FPGA ou un micro-contrôleur, par exemple un processeur de signal numérique, qui reçoit une copie du signal injecté s(t) et la mesure du signal réfléchi r(t) et est configuré pour exécuter le procédé décrit à la figure 2 afin de déterminer les caractéristiques d'un défaut non franc.

Le moyen GS peut être constitué par un générateur de signal analogique, par exemple un signal sous la forme d'une impulsion Gaussienne ou tout autre signal à support temporel limité. Le moyen d'injection du signal dans le câble peut être constitué par un coupleur qui peut également servir à acquérir une mesure du signal réfléchi. Si le signal est généré numériquement, le moyen GS comprend également un convertisseur numérique analogique pour convertir le signal numérique en un signal analogique avant son injection dans le câble et un convertisseur analogique numérique pour réaliser l'opération inverse après l'acquisition de la mesure du signal réfléchi.

L'injection du signal dans le câble et la mesure du signal réfléchi peuvent être réalisées par un seul et même composant mais aussi par deux composants distincts, notamment lorsque le point d'injection et le point de mesure sont dissociés.

Le système décrit à la figure 5 peut être mis en oeuvre par une carte électronique sur laquelle sont disposés les différents composants. Le moyen de couplage et d'injection peut être connecté à une entrée/sortie que comporte la carte.

En outre, une unité de traitement, de type ordinateur, assistant numérique personnel ou autre peut être utilisée pour piloter le dispositif de réflectométrie et afficher les résultats des calculs effectués par le composant MC sur une interface homme-machine.

Le procédé selon l'invention peut être implémenté sur le composant MC à partir d'éléments matériels et/ou logiciels.

Lorsque le composant MC est implémenté à partir d'éléments matériels, il comporte au moins un second générateur de signal GS2 pour produire un signal de référence s' modifié à partir du signal de référence s et des paramètres de retard et d'amplitude. Un comparateur ERR permet de calculer l'erreur entre le signal de référence s' modifié et la signature d'un défaut non franc dans la mesure du signal réfléchi r. Un module de calcul MIN effectue la recherche de l'erreur minimale et des paramètres de retard $t_d$ et d'amplitude $A_d$ associés.

Un module de calcul CALC permet enfin de déterminer les caractéristiques du défaut en termes de longueur, impédance caractéristique et position à partir des valeurs de retard $t_d$ et d'amplitude $A_d$ fournies.

Le procédé selon l'invention peut également être mis en oeuvre exclusivement en tant que programme d'ordinateur, le procédé étant alors appliqué à une mesure de réflectométrie r préalablement acquise à l'aide d'un dispositif de réflectométrie usuel. Dans un tel cas, l'invention peut être mise en oeuvre en tant que programme d'ordinateur comportant des instructions pour son exécution. Le programme d'ordinateur peut être enregistré sur un support d'enregistrement lisible par un processeur.

Références

[1] G.F. Knoll : Radiation Détection and Measurement. Wiley, 2nd ed., 1989

[2] T. Trigano, E. Barat, T. Dautremer et T. Brisset : Mesure et Traitement d'un Signal Comprenant des Empilements d'Impulsions Elémentaires , Brevet Français 2 870 603

[3] T. Trigano, E. Barat, T. Dau-tremer et A. Souloumiac : Pileup Correction Algorithms for Nuclear Spectrometry, IEEE International Conference on Acoustics, Speech and Signal Processing, 2005

[4] M. Nakhostin, Zs. Podolyak, P. H. Regan, P. M. Walker : A digital method for separation and reconstruction of pile-up events in germanium detectors, Department of Physics, University of Surrey, Guildford GU2 7XH, UK

**Revendications**

1. Procédé de caractérisation d'un défaut impactant un câble dans lequel un signal de référence s de support temporel limité est injecté et une mesure r de la réflexion dudit signal de référence s dans le câble est réalisée, **caractérisé en ce que** ledit procédé comprend les étapes suivantes :

    - Identifier (201) une portion de la mesure r correspondant à un défaut, cette portion de mesure étant appelée signature du défaut,
    - Générer (202) un signal de référence s' modifié, d'amplitude paramétrable, égal à la somme dudit signal de référence s et dudit signal de référence s inversé et retardé d'un retard paramétrable,
    - Déterminer (203) conjointement les valeurs du retard paramétrable et de l'amplitude paramétrable qui minimisent l'erreur entre le signal de référence s' modifié et la signature du défaut,
    - En déduire (204) une estimation de la longueur du défaut à partir de la valeur dudit retard déterminée.

2. Procédé de caractérisation d'un défaut impactant un câble selon la revendication 1 comprenant en outre l'étape suivante :

    - Déduire (206), à partir de la valeur d'amplitude déterminée, une estimation du coefficient de réflexion du signal au niveau du défaut puis une estimation de l'impédance caractéristique du câble au niveau du défaut.

3. Procédé de caractérisation d'un défaut impactant un câble selon l'une des revendications précédentes dans lequel la durée du support temporel du signal de référence s est rendue paramétrable, ledit procédé comprenant en outre une étape ($203_{bis}$) de détermination de la valeur de ladite durée qui minimise l'erreur entre le signal de référence s' modifié et la signature du défaut.

4. Procédé de caractérisation d'un défaut impactant un câble selon l'une des revendications précédentes comprenant en outre les étapes suivantes :

    - Déterminer (206) une estimation de la position du milieu du défaut à partir de la signature du défaut dans la mesure r de la réflexion du signal de référence,
    - Déterminer (206) une estimation de la position du début du défaut en retranchant à la position du milieu du défaut la moitié de la longueur du défaut.

5. Procédé de caractérisation d'un défaut impactant un câble selon la revendication 4 dans lequel on détermine une estimation de la position du milieu du défaut à partir du milieu de l'intervalle temporel [t1 ; t2] avec t1 l'abscisse temporelle de l'amplitude maximum de la signature du défaut et t2 l'abscisse temporelle de l'amplitude minimum de la signature du défaut.

6. Procédé de caractérisation d'un défaut impactant un câble selon l'une des revendications précédentes dans lequel le signal de référence s est une impulsion temporelle.

7. Programme d'ordinateur comportant des instructions pour l'exécution du procédé de caractérisation d'un défaut impactant un câble selon l'une quelconque des revendications 1 à 6, lorsque le programme est exécuté par un processeur.

8. Support d'enregistrement lisible par un processeur sur lequel est enregistré un programme comportant des instructions pour l'exécution du procédé de caractérisation d'un défaut impactant un câble selon l'une quelconque des revendications 1 à 6, lorsque le programme est exécuté par un processeur.

9. Dispositif de caractérisation d'un défaut impactant un câble comprenant des moyens (GS,MI) d'injection d'un signal de référence s en un point du câble, des moyens de mesure (MI) d'une réflexion r dudit signal dans le câble et des moyens de calcul (MC) adaptés pour mettre en oeuvre le procédé de caractérisation d'un défaut impactant un câble selon l'une quelconque des revendications 1 à 6.

**Patentansprüche**

1. Verfahren zum Charakterisieren eines Fehlers in einem Kabel, bei welchem ein begrenztes zeitliches Support-Referenzsignal s injiziert wird und eine Messung r der Reflexion des Referenzsignals s im Kabel durchgeführt wird, **dadurch gekennzeichnet, dass** es folgende Schritte beinhaltet:

   - Identifizieren (201) eines Abschnitts der Messung r, welcher einem Fehler entspricht, wobei dieser Messungsabschnitt Fehlersignatur genannt wird,
   - Erzeugen (202) eines modifizierten Referenzsignals s' mit parametrierbarer Amplitude, gleich der Summe des Referenzsignals s und des invertierten und um eine parametrierbare Verzögerung verzögerten Referenzsignals s,
   - gleichzeitiges Bestimmen (203) der Werte der parametrierbaren Verzögerung und der parametrierbaren Amplitude, welche den Fehler zwischen dem modifizierten Referenzsignal s' und der Fehlersignatur minimieren,
   - hieraus Ableiten (204) einer Schätzung der Länge des Fehlers anhand des bestimmten Wertes der Verzögerung.

2. Verfahren zum Charakterisieren eines Fehlers in einem Kabel nach Anspruch 1, welches zudem folgenden Schritt beinhaltet:

   - Ableiten (206), anhand des bestimmten Amplitudenwertes, einer Schätzung eines Reflexionskoeffizienten des Signals auf Höhe des Fehlers, gefolgt von einer Schätzung der charakteristischen Impedanz des Kabels auf Höhe des Fehlers.

3. Verfahren zum Charakterisieren eines Fehlers in einem Kabel nach einem der vorhergehenden Ansprüche, bei welchem die Dauer des zeitlichen Supports des Referenzsignals s parametrierbar gemacht wird, wobei das Verfahren zudem einen Schritt (203$_{bis}$) des Bestimmens des Wertes der Dauer beinhaltet, welcher den Fehler zwischen dem modifizierten Bezugssignal s' und der Fehlersignatur minimiert.

4. Verfahren zum Charakterisieren eines Fehlers in einem Kabel nach einem der vorhergehenden Ansprüche, welches zudem folgende Schritte beinhaltet:

   - Bestimmen (206) einer Schätzung der Position der Mitte des Fehlers anhand der Fehlersignatur in der Messung r der Reflexion des Bezugssignals,
   - Bestimmen (206) einer Schätzung der Position des Anfangs des Fehlers durch Abziehen von der Mittenposition des Fehlers der Hälfte der Fehlerlänge.

5. Verfahren zum Charakterisieren eines Fehlers in einem Kabel nach Anspruch 4, bei welchem man eine Schätzung der Mittenposition des Fehlers anhand der Mitte des Zeitintervalls [t1; t2] bestimmt, wobei t1 die Zeit-Abszisse der maximalen Amplitude der Fehlersignatur und t2 die Zeit-Abszisse der minimalen Amplitude der Fehlersignatur ist.

6. Verfahren zum Charakterisieren eines Fehlers in einem Kabel nach einem der vorhergehenden Ansprüche, bei welchem das Referenzsignal s ein zeitlicher Impuls ist.

7. Computerprogramm, beinhaltend Anweisungen zur Ausführung des Verfahrens zum Charakterisieren eines Fehlers in einem Kabel nach einem der Ansprüche 1 bis 6, wenn das Programm von einem Prozessor ausgeführt wird.

8. Aufzeichnungsträger, welcher durch einen Prozessor lesbar ist, auf welchem ein Programm aufgezeichnet ist, welches Anweisungen zur Ausführung des Verfahrens zum Charakterisieren eines Fehlers in einem Kabel nach einem der Ansprüche 1 bis 6 beinhaltet, wenn das Programm von einem Prozessor ausgeführt wird.

9. Vorrichtung zum Charakterisieren eines Fehlers in einem Kabel, welches Mittel (GS, MI) zum Injizieren eines Referenzsignals s an einem Punkt des Kabels, Mittel zum Messen (MI) einer Reflexion r des Signals im Kabel und Mittel zum Berechnen (MC) beinhaltet, welche geeignet sind, das Verfahren zum Charakterisieren eines Fehlers in einem Kabel nach einem der Ansprüche 1 bis 6 umzusetzen.

**Claims**

1. A method for characterizing a fault affecting a cable in which a reference signal s of limited time support is injected and a measurement r of the reflection of said reference signal s in the cable is taken, **characterized in that** said method comprises the following steps:

   - identifying (201) a section of the measurement r corresponding to a fault, this measurement section being called the signature of the fault;
   - generating (202) a modified reference signal s', of parameterizable amplitude, equal to the sum of said reference signal s and of said reference signal s inverted and delayed by a parameterizable delay;
   - determining (203) conjointly the values of the parameterizable delay and of the parameterizable amplitude that minimize the error between the modified reference signal s' and the signature of the fault;

- deducing (204) therefrom an estimation of the length of the fault from the determined value of said delay.

2. The method for characterizing a fault affecting a cable as claimed in claim 1, furthermore comprising the following step:

- Deducing (206), from the determined amplitude value, an estimation of the reflection coefficient of the signal level with the fault then an estimation of the characteristic impedance of the cable level with the fault.

3. The method for characterizing a fault affecting a cable as claimed in either one of the preceding claims, wherein the duration of the time support of the reference signal s is made parameterizable, said method furthermore comprising a step ($203_{bis}$) of determining the value of said duration that minimizes the error between the modified reference signal s' and the signature of the fault.

4. The method for characterizing a fault affecting a cable as claimed in one of the preceding claims furthermore comprising the following steps:

- determining (206) an estimation of the position of the middle of the fault from the signature of the fault in the measurement r of the reflection of the reference signal;
- determining (206) an estimation of the position of the start of the fault by subtracting from the position of the middle of the fault half the length of the fault.

5. The method for characterizing a default affecting a cable as claimed in claim 4, wherein an estimation of the position of the middle of the fault is determined from the middle of the time interval [t1 ; t2] where t1 is the time abscissa of the maximum amplitude of the signature of the fault and t2 the time abscissa of the minimum amplitude of the signature of the fault.

6. The method for characterizing a fault affecting a cable as claimed in one of the preceding claims, wherein the reference signal s is a time-domain pulse.

7. A computer program including instructions for executing the method for characterizing a fault affecting a cable as claimed in any one of claims 1 to 6, when the program is executed by a processor.

8. A processor-readable storage medium on which is stored a program including instructions for executing the method for characterizing a fault affecting a cable as claimed in any one of claims 1 to 6, when the program is executed by a processor.

9. A device for characterizing a fault affecting a cable comprising means (GS, MI) for injecting a reference signal s at a point of the cable, means (MI) for measuring a reflection r of said signal in the cable and computing means (MC) suitable for implementing the method for characterizing a fault affecting a cable as claimed in any one of claims 1 to 6.

FIG.1a

$$\Gamma_1 = \frac{Z_{c2} - Z_{c1}}{Z_{c2} + Z_{c1}}$$

$$\Gamma_2 = \frac{Z_{c1} - Z_{c2}}{Z_{c1} + Z_{c2}}$$

FIG.1b

EP 3 259 608 B1

FIG.2

FIG.3

EP 3 259 608 B1

FIG.4

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2008157897 B
- FR 2870603

**Littérature non-brevet citée dans la description**

- **G.F. KNOLL.** Radiation Détection and Measurement. Wiley, 1989
- **T. TRIGANO ; E. BARAT ; T. DAU-TREMER ; A. SOULOUMIAC.** Pileup Correction Algorithms for Nuclear Spectrometry. *IEEE International Conference on Acoustics, Speech and Signal Processing,* 2005
- **M. NAKHOSTIN ; ZS. PODOLYAK ; P. H. REGAN ; P. M. WALKER.** A digital method for separation and reconstruction of pile-up events in germanium detectors. Department of Physics, University of Surrey